# EUROPEAN PATENT APPLICATION

(11) **EP 2 611 091 A2**
(43) Date of publication of application: **03.07.2013**
(21) Application number: 12198345.6
(22) Date of filing: 20.12.2012
(51) Int. Cl.: H04L 27/34

(54) **Hierarchical modulation and demodulation apparatus and method**

(30) Priority: 02.01.2012 KR 20120000144
(71) Applicant: Samsung Electronics Co., Ltd., Suwon-si, Gyeonggi-do 442-742 (KR); Industry-Academic Cooperation Foundation Yonsei University, Seoul 120-479 (KR)
(72) Inventor: Park, Chang Soon, Gyeonggi-do 446-712 (KR); Kim, Young Soo, Gyeonggi-do 446-712 (KR); Bae, Chi Sung, Gyeonggi-do 446-712 (KR); Hwang, Hyo Sun, Gyeonggi-do 446-712 (KR); Kim, Yong Ok, Seoul 120-479 (KR); Jung, Min Chae, Seoul 120-479 (KR); Choi, Soo Yong, Seoul 120-479 (KR); Hwang, Kyu Ho, Seoul 120-479 (KR)
(74) Representative: Land, Addick Adrianus Gosling

(57) **Abstract**

An apparatus and method for hierarchical modulation and demodulation in a wireless communication network are provided. A hierarchical modulation apparatus may map information bits to a plurality of levels based on a predetermined level map, may generate an error verification code for each of the levels based on the information bits mapped to the levels, may generate coded information bits for each of the levels, and may map bits in a predetermined position among the coded information bits, to Pulse-Position Modulation (PPM) symbols in a sequence of the levels.

## Description

This application claims the benefit of Korean Patent Application No. 10-2012-0000144, filed on January 2, 2012, in the Korean Intellectual Property Office, the entire disclosure of which is incorporated herein by reference for all purposes.

The following description relates to an apparatus and method for hierarchical modulation and demodulation in a wireless communication network.

Currently, sensor networks are quickly becoming widespread due to rapid development and commercialization of wireless network technologies. A wireless sensor device may be used in various fields, for example, home security, medical applications, mobile healthcare, monitoring of chemical/biological features, mechanical failure diagnosis, environmental monitoring, sensing of information regarding disasters, intelligent physical distribution management, real-time security, remote monitoring, and the like.

In various Wireless Sensor Networks (WSNs) and Personal Area Networks (PANs), it is desirable for sensors to be compact, and conditions, such as low power and low complexity, are typically required to operate a large number of sensors over a long period of time.

In particular, a sensor that senses signals of a human body may require low power and low complexity more stringently in a Wireless Body Area Network (WBAN) that enables the sensor to perform wireless communication with a mobile device around the sensor, or with another sensor in around the human body.

In one general aspect, there is provided a hierarchical modulation apparatus, including a level mapping unit configured to map information bits to a plurality of levels based on a predetermined level map, an error control unit configured to generate an error verification code for each of the levels based on the mapped information bits, an encoding unit configured to generate coded information bits for each of the levels, based on the generated error verification code and the mapped information bits, and a symbol mapping unit configured to map bits at a predetermined position among the coded information bits, to Pulse-Position Modulation (PPM) symbols, in a sequence of the levels.

The level mapping unit may be configured to map the information bits to 'N' levels from levels 1 through N, and the error control unit may be configured to generate an error verification code for level N by accumulating each of the information bits mapped for levels 1 through N.

The encoding unit may be configured to generate a parity for level N, based on the error verification code for level N and the information bits mapped for levels 1 through N, and to generate coded information bits for level N by concatenating the parity for level N, the information bits mapped to level N, and the error verification code for level N.

The symbol mapping unit may be further configured to select a single bit from among the coded information bits for each of the 'N' levels, concatenate the selected bits in a sequence of the 'N' levels, and map the concatenated bits to the PPM symbols.

The PPM symbols may comprise a constant period regardless of a number of the levels.

The PPM symbols may comprise the same pulse durations regardless of a number of the levels.

The symbol mapping unit may be further configured to select a single bit from among the coded information bits for each of the 'N' levels, concatenate the selected bits in the sequence of the 'N' levels, and perform gray mapping to map the concatenated bits to the PPM symbols.

The hierarchical modulation apparatus may further comprise a transmitting unit configured to transmit a control signal comprising information about the modulation of the levels, and a receiving unit configured to receive a response signal comprising error occurrence information and information on a demodulation order.

The hierarchical modulation apparatus may further comprise a control unit configured to map information bits to a PPM symbol based on the same modulation order as the demodulation order, and based on the error occurrence information and the information on the demodulation order received by the receiving unit, in response to the information bits being requested to be retransmitted.

The hierarchical modulation apparatus may be included in a sensor in a Wireless Sensor Network (WSN).

In another aspect, there is provided a hierarchical demodulation apparatus, including a demodulating and decoding unit configured to demodulate a received signal based on a demodulation order, and to decode coded information bits, and an error detecting unit configured to detect an error from the received signal, based on an error verification code that is included in the coded information bits.

The demodulating and decoding unit may be configured to demodulate the received signal using Pulse-Position Modulation (PPM) symbols based on the demodulation order, and estimate, from the demodulated signal, bit values from level 1 to a level corresponding to the demodulation order.

The error detecting unit may be configured to detect the error from the received signal based on a Cyclic Redundancy Check (CRC) code that is included in the estimated bit values.

The hierarchical demodulation apparatus may further comprise a noise estimating and cancelling unit configured to estimate noise generated due to a difference between a modulation order of a transmitter and a demodulation order of a receiver, and to remove the estimated noise.

The hierarchical demodulation apparatus may further comprise a retransmission request determining unit configured to determine whether to request the transmitter to retransmit information bits for a level that is higher than a level in which the error is detected, in response to the error being detected in the received signal.

The hierarchical demodulation apparatus may further comprise a receiving unit configured to receive PPM symbols, and a transmitting unit configured to transmit a response signal that comprises information about a level in which the error is detected, and information about the demodulation order.

The demodulation order may be set to 'K,' and the demodulating and decoding unit may comprise 'K' branch demodulating and decoding units, and each of the 'K' branch demodulating and decoding units may be configured to estimate bits for levels 1 to K, respectively, using an iterative decoding scheme that enables the 'K' branch demodulating and decoding units to exchange extrinsic information with each other.

The error detecting unit may comprise 'K' branch error detecting units that are respectively connected to the 'K' branch demodulating and decoding units, and each of the 'K' branch error detecting units may be configured to detect an error from the estimated bits for each level, respectively, based on a CRC code included in the estimated bits.

The error detecting unit may comprise 'K' branch error detecting units that are respectively connected to the 'K' branch demodulating and decoding units, and the 'K^{th}' branch error detecting unit may be configured to detect an error from the estimated bits for the 1^{st} level to the K^{th} level based on a CRC code included in the estimated bits prior to the remaining branch error detecting units performing detecting.

In response to the K^{th} branch error detecting unit not detecting an error, the remaining branch error detecting units may be controlled not to operate.

The hierarchical demodulation apparatus is included in a sensor in a Wireless Sensor Network (WSN).

In another aspect, there is provided a hierarchical modulation method, including mapping information bits to a plurality of levels based on a predetermined level map, generating an error verification code for each of the levels based on the mapped information bits, generating coded information bits for each of the levels based on the generated error verification code and the mapped information bits, and mapping bits at a predetermined position among the coded information bits, to Pulse-Position Modulation (PPM) symbols, in a sequence of the levels.

The information bits may be mapped to 'N' levels from levels 1 through N, and the generating of the error verification code may comprise generating an error verification code for level N by accumulating each of the information bits mapped for levels 1 through N.

The generating of the coded information bits may comprise generating a parity for level N, based on the error verification code for level N and the information bits mapped for levels 1 through N, and generating coded information bits for level N by concatenating the parity for level N, the information bits mapped to level N, and the error verification code for level N.

The mapping of the bits may comprise selecting a single bit from among the coded information bits for each of 'N' levels, concatenating the selected bits in a sequence of the 'N' levels, and mapping the concatenated bits to the PPM symbols.

In another aspect, there is provided a hierarchical demodulation method, including demodulating a received signal based on a demodulation order, decoding coded information bits, and detecting an error from the received signal, based on an error verification code included in the coded information bits.

The demodulating may comprise demodulating the received signal using Pulse-Position Modulation (PPM) symbols based on the demodulation order, and the decoding may comprise estimating, from the demodulated signal, bit values from level 1 to a level corresponding to the demodulation order.

Other features and aspects will be apparent from the following detailed description, the drawings, and the claims.

### BRIEF DESCRIPTION OF THE DRAWINGS

FIG. 1 is a diagram illustrating an example of a hierarchical modulation apparatus.
FIG. 2 is a diagram illustrating another example of a hierarchical modulation apparatus.
FIG. 3 is a diagram illustrating an example of an encoding operation.
FIG. 4 is a diagram illustrating an example of a hierarchical modulation operation.
FIG. 5 is a diagram illustrating an example of a hierarchical demodulation apparatus.
FIG. 6 is a diagram illustrating another example of a hierarchical demodulation apparatus.
FIGS. 7 through 10 are diagrams illustrating examples of waveforms of Pulse-Position Modulation (PPM) symbols with a constant period.
FIGS. 11 through 14 are diagrams illustrating examples of waveforms of PPM symbols with the same pulse durations.
FIG. 15 is a diagram illustrating an example of operations of a transmitter and a receiver in an example in which retransmission of information bits is possible in a hierarchical modulation/demodulation system.
FIG. 16 is a diagram illustrating an example of results of demodulating and decoding performed by receivers with various demodulation orders, in an example in which retransmission of information bits is not possible in a hierarchical modulation/demodulation system.

Throughout the drawings and the detailed description, unless otherwise described, the same drawing reference numerals will be understood to refer to the same elements, features, and structures. The relative size and depiction of these elements may be exaggerated for clarity, illustration, and convenience.

### DETAILED DESCRIPTION

The following detailed description is provided to assist the reader in gaining a comprehensive understanding of the methods, apparatuses, and/or systems described herein. Accordingly, various changes, modifications, and equivalents of the methods, apparatuses, and/or systems described herein will be suggested to those of ordinary skill in the art. Also, description of well-known functions and constructions may be omitted for increased clarity and conciseness.

A hierarchical modulation/demodulation technique used in a digital broadcasting standard, for example a Digital Video Broadcasting-Terrestrial (DVB-T), may be based on a coherent transceiver employing a modulation scheme, for example a Phase-Shift Keying (PSK) scheme, a Quadrature Amplitude Modulation (QAM) scheme, and the like.

However, because it is desirable to reduce the unit cost, power consumption, and complexity of a transceiver in a Wireless Body Area Network (WBAN), and a Wireless Sensor Network (WSN), the coherent scheme may not be desirable to use. Instead, a non-coherent modulation/demodulation technique with lower complexity than the coherent scheme may be used. The non-coherent modulation/demodulation technique may include, for example, a Pulse-Position Modulation (PPM) scheme.

As described in various examples herein, a hierarchical modulation/demodulation system may be used in a wireless communication system employing a transceiver with a simple structure using a PPM. The simpler structure may provide a more desired system that has a reduction in a form factor, a unit cost, and the like, similarly to the WBAN and the WSN.

As described in various examples herein, a hierarchical modulation/demodulation system may enable a system employing the PPM to select a demodulation order based on a demodulation order and a bandwidth for each receiver, to implement hierarchical modulation and demodulation. For example, receivers with different demodulation orders may use a signal that is pulse position modulated with a single modulation order by a transmitter.

As described herein, the transmitter and/or the receiver may correspond to a terminal, for example, a sensor, a mobile node, an access point, a computer, and the like.

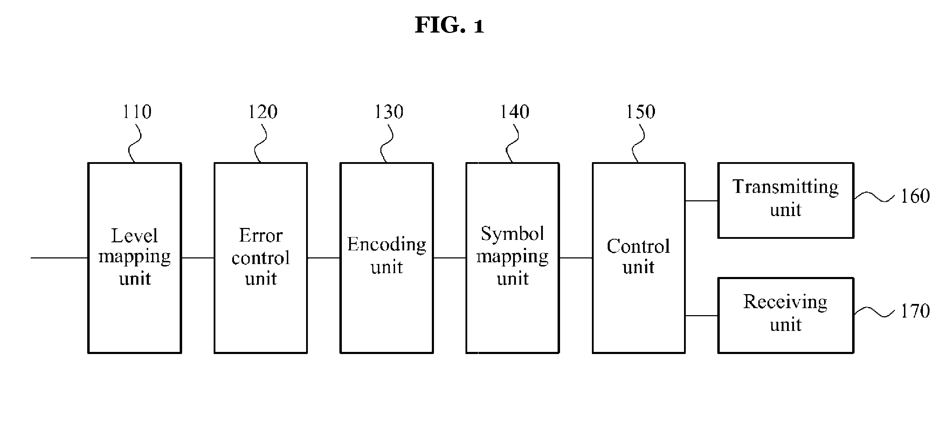

FIG. 1 illustrates an example of a hierarchical modulation apparatus.

Referring to FIG. 1, the hierarchical modulation apparatus includes a level mapping unit 110, an error control unit 120, an encoding unit 130, a symbol mapping unit 140, a control unit 150, a transmitting unit 160, and a receiving unit 170. The hierarchical modulation apparatus of FIG. 1 may correspond to a transmitter of a hierarchical modulation/demodulation system. The transmitter and the receiver described herein may be, or may be included in a terminal, for example, a smart phone, a laptop computer, a tablet, a sensor, a base station, and the like, which may be used in a wireless network environment.

The level mapping unit 110 may map information bits to a plurality of levels, based on a predetermined level map. The information bits may be stored in storage space, for example a queue. As an example, the information bits may refer to bits of media including information about images, sound, data, and the like. For example, information bits may represent the colors of an image. In addition, information about the same source, or information about different sources may be stored in each queue.

The level mapping unit 110 may map information bits stored in each queue, for each of the levels, based on a predetermined level map. For example, the level mapping unit 110 may map information bits stored in queue 1 to level 4, and may map information bits stored in queue 2 to level 5. The levels may be determined based on a modulation order.

The error control unit 120 may generate an error verification code for each of the levels, based on the information bits that are mapped to the levels by the level mapping unit 110. The error verification code may include, for example, a Cyclic Redundancy Check (CRC) code. In this example, as the levels rise, the error control unit 120 may generate an error verification code by accumulating information bits that are mapped to lower levels.

The encoding unit 130 may generate coded information bits for each of the levels, based on the mapped information bits and the generated error verification code. The coded information bits may include a parity. For example, coded information bits may be generated for a single level. In this example, the encoding unit 130 may generate a parity based on information bits mapped to levels lower than the single level, and an error verification code included in the single level.

The symbol mapping unit 140 may map bits at a predetermined position among the coded information bits, to PPM symbols in a sequence of the levels. For example, the symbol mapping unit 140 may map information bits at a first position to a first PPM symbol for each of the levels, and may map information bits at a second position to a second PPM symbol for each of the levels.

As an example, the level mapping unit 110 may map information bits to 'N' levels such as levels 1 to N. In this example, the error control unit 120 may generate an error verification code for level N, by accumulating all of the information bits mapped for levels 1 to N. In this example, the encoding unit 130 may generate a parity for level N, based on the error verification code for level N and the information bits mapped to levels 1 to N. Additionally, the encoding unit 130 may generate coded information bits for level N by concatenating the parity for level N, the information bits mapped to level N, and the error verification code for level N. The symbol mapping unit 140 may select a bit from among the coded information bits for each of the 'N' levels, may concatenate the selected bits in a sequence of the 'N' levels, and may map the concatenated bits to PPM symbols.

For example, the symbol mapping unit 140 may select a single bit from among the coded information bits for each of the 'N' levels, may concatenate the selected bits in the sequence of the 'N' levels, and may perform gray mapping to map the concatenated bits to PPM symbols. The gray mapping may generate a 1-bit difference between symbol bits of neighboring symbols.

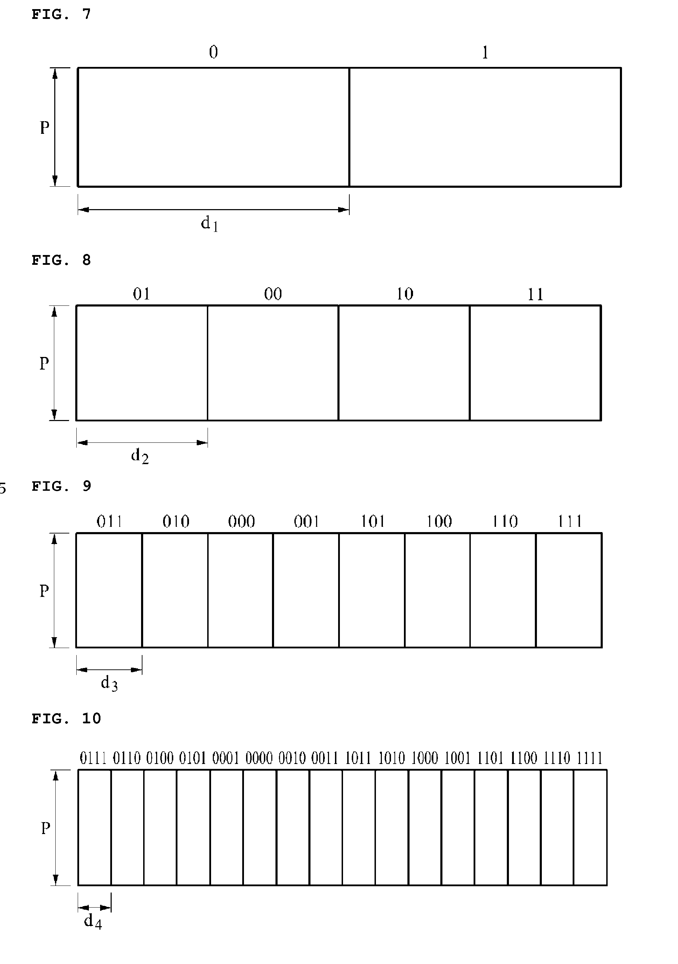

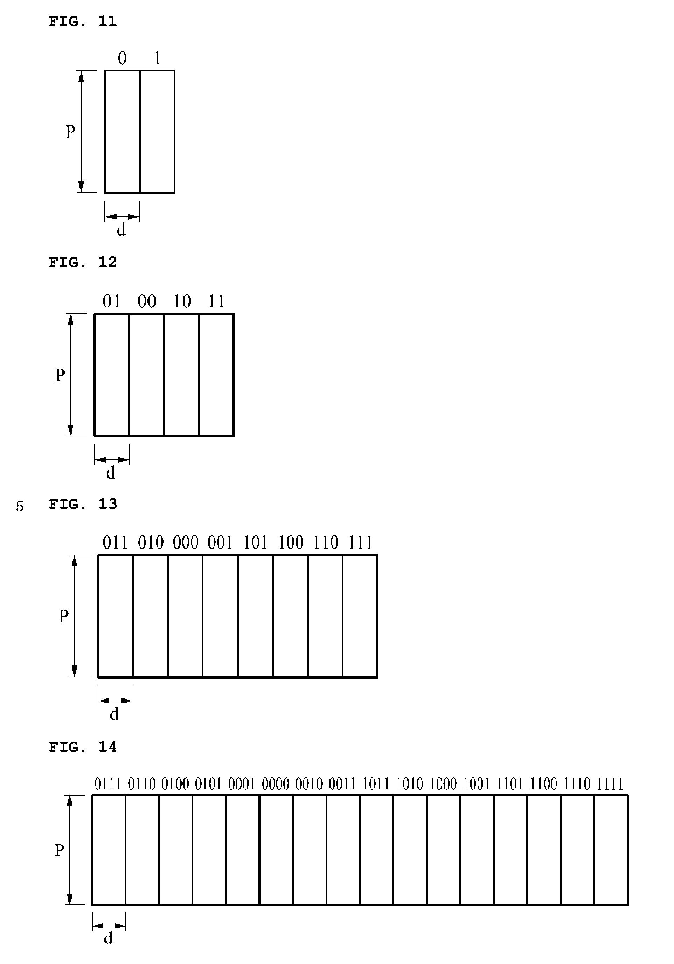

The PPM symbols may have a constant period regardless of a number of levels. For example, a total period of all of the PPM symbols may remain unchanged, despite a change in the modulation order, examples of which are illustrated in FIGS. 7 through 10. The PPM symbols may have the same pulse durations regardless of the number of levels. For example, a pulse interval of each of the PPM symbols may have a constant duration, examples of which are illustrated in FIGS. 11 through 14.

The transmitting unit 160 may transmit a control signal including information about the modulation order. The modulation order may correspond to the number of the levels. For example, the transmitting unit 160 may transmit the information on the modulation order of the transmitter to a receiver of the hierarchical modulation/demodulation system.

The receiving unit 170 may receive a response signal from a receiver. The response signal may include error occurrence information and information on a demodulation order of the receiver. For example, the receiving unit 170 may receive information on an error verification code in which an error occurs, and the information on the demodulation order of the receiver.

The control unit 150 may map information bits that are requested by the receiver to be retransmitted, to a PPM symbol, based on the error occurrence information and information on the demodulation order that are received by the receiving unit 170. The control unit may map information bits to the PPM symbol based on the same modulation order as the demodulation order. For example, in response to the receiver receiving '110' instead of '111,' information notifying that an error occurs in a third level may be transmitted. In this example, the control unit 150 may map information bit '1' for a third level to a PPM symbol. Accordingly, the transmitting unit 160 may transmit the information bit '1' mapped to the PPM symbol to the receiver.

The control unit 150 may control an overall operation of the hierarchical modulation apparatus of FIG. 1, and may perform one or more functions of one or more of the level mapping unit 110, the error control unit 120, the encoding unit 130, the symbol mapping unit 140, the transmitting unit 160 and the receiving unit 170. For purposes of example, the level mapping unit 110, the error control unit 120, the encoding unit 130, the symbol mapping unit 140, the control unit 150, the transmitting unit 160 and the receiving unit 170 are separately illustrated in FIG. 1. However, it should be appreciated that the control unit 150 may be configured to perform one or more of the functions, or a portion of one or more of the functions.

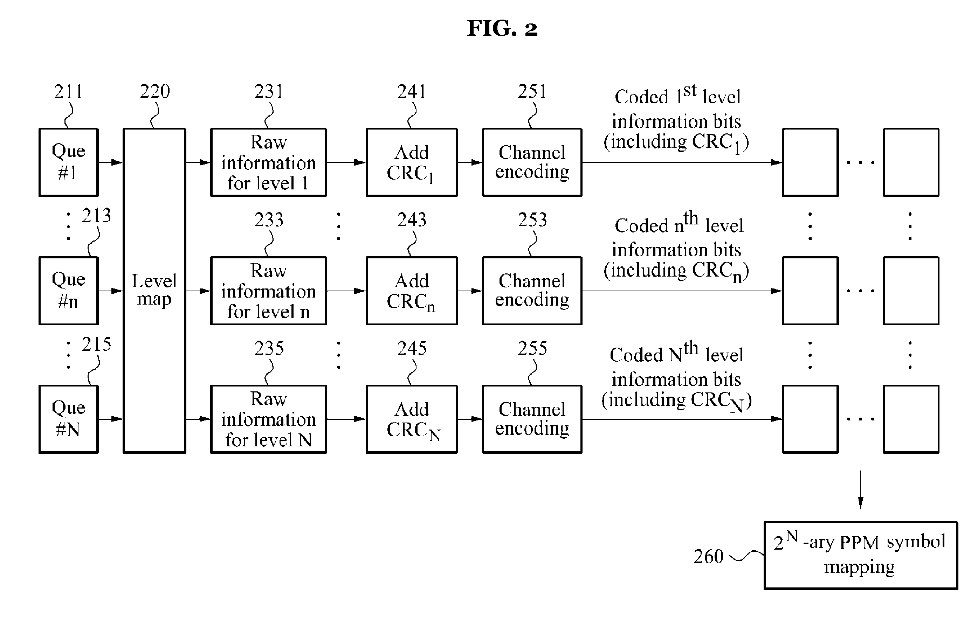

FIG. 2 illustrates another example of a hierarchical modulation apparatus.

Referring to FIG. 2, for example, the hierarchical modulation apparatus may be a transmitter of a hierarchical modulation/demodulation system.

Raw information bits stored in queues 211, 213, and 215 of the hierarchical modulation apparatus may be mapped to 'N' levels, based on a level map 220. As an example, the level map 220 may be set in advance by the hierarchical modulation/demodulation system. The raw information bits stored in the queues 211, 213, and 215 may include information about a single source, or information about a plurality of sources.

The hierarchical modulation apparatus may generate error verification code bits 241, 243, and 245 for each of the 'N' levels, based on the mapped raw information bits 231, 233, and 235. A CRC code may be used as an error verification code. For example, the hierarchical modulation apparatus may generate CRC₁ bits 241 for level 1 based on the raw information bits 231 for level 1, and may generate CRCₙ bits 243 for level n by accumulating the raw information bits 231 to 233 mapped to levels 1 through n. As another example, the hierarchical modulation apparatus may generate CRC_{N} bits 245 for level N by accumulating the raw information bits 231 to 235 mapped to levels 1 through N.

The CRC₁ bits 241 may be added to the raw information bits 231 for level 1. Also, the CRCₙ bits 243 may be added to the raw information bits 233 for level n, and CRC_{N} bits 245 may be added to the raw information bits 235 for level N.

The hierarchical modulation apparatus may perform channel encoding for each of the 'N' levels, as represented in 251, 253, and 255. Information bits coded through the channel encoding may be mapped to 2^{N}-ary PPM symbols in 260. For example, N may correspond to a modulation order. As an example, if the modulation order is set to '3,' raw information bits may be coded for each of three levels, and the raw information bits for the three levels may be mapped to eight PPM symbols.

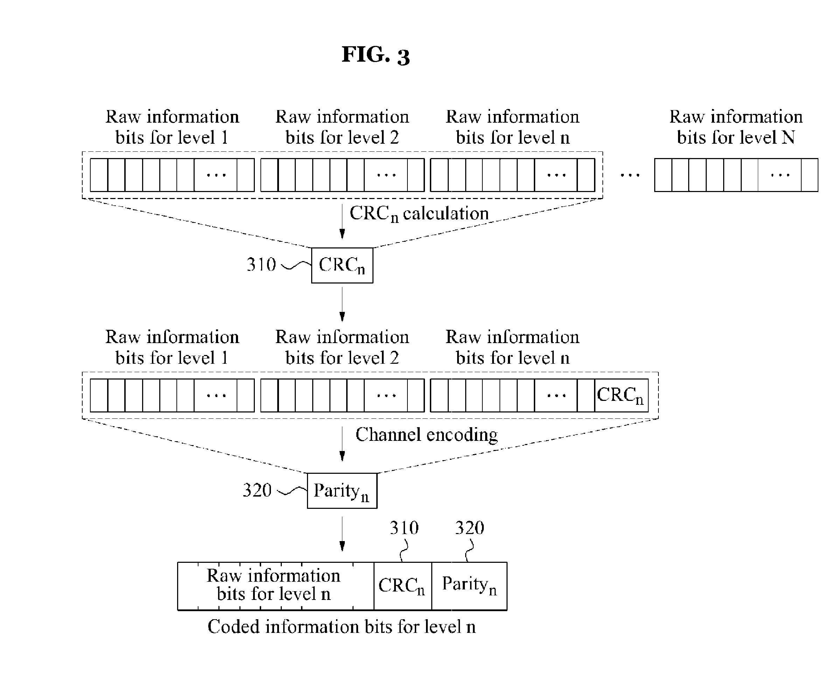

FIG. 3 illustrates an example of an encoding operation.

In this example, an error verification code for level n and a parity for level n are generated through the encoding operation.

Referring to FIG. 3, a CRC code may be used as an error verification code. The error verification code for level n may be a CRCₙ 310. The CRCₙ 310 refers to CRC bits added to level n, and a parityₙ 320 refers to parity bits added to level n through the encoding operation. The encoding operation may indicate channel encoding.

In this example, the CRCₙ 310 may be calculated by accumulating all raw information bits for levels 1 to n. The parityₙ 320 may be calculated by accumulating the CRCₙ 310 and the raw information bits for levels 1 through n.

Coded information bits for level n may be generated by concatenating the CRCₙ 310 and parityₙ 320 with the raw information bits for level n. For example, the operation of adding and encoding CRC bits may be performed for each level, and coded information bits for each level may be generated.

Raw information bits for each level may tend to be robust against noise and synchronization error based on levels. For example, a CRC₁ and a parity₁ may be calculated based on only raw information bits for level 1. As another example, a CRC_{N} and a parity_{N} may be calculated based on all raw information bits for levels 1 to N. In this example, the raw information bits for level 1 may have a low encoding rate and accordingly, the raw information bits for level 1 may be highly robust against noise. The closer a level to level 1, the closer raw information bits for the level are to a Most Significant Bit (MSB) of a PPM symbol. In this example, the raw information bits may be demodulated with a low demodulation order by a receiver. Accordingly, raw information bits may be highly robust against inaccurate time synchronization.

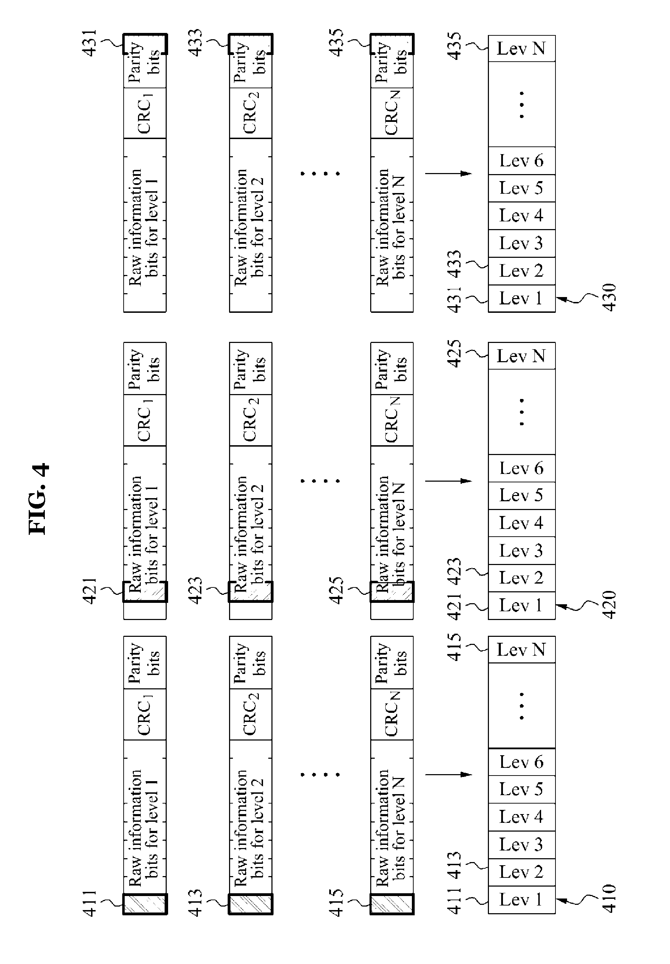

FIG. 4 illustrates an example of a hierarchical modulation operation.

In this example, coded information bits are mapped to PPM symbols.

Referring to FIG. 4, a hierarchical modulation apparatus may select a single bit from among coded information bits for each of levels 1 to N, may concatenate the selected bits in a sequence of levels 1 to N, and may map the concatenated bits to 2^{N}-ary PPM symbols.

For example, among the bits mapped to the 2^{N}-ary PPM symbols, a bit selected from the information bits for level 1 may be located in an MSB of a corresponding PPM symbol, and the bit selected from the information bits for level N may be located in a Least Significant Bit (LSB) of the PPM symbol.

In this example, a first bit 411 from among coded information bits for level 1, a first bit 413 from among coded information bits for level 2, and a first bit 415 from among coded information bits for level N may be concatenated in the sequence of levels 1 to N, and may be mapped to a first PPM symbol 410.

Furthermore, a second bit 421 from among the coded information bits for level 1, a second bit 423 from among the coded information bits for level 2, and a second bit 425 from among the coded information bits for level N may be concatenated in the sequence of levels 1 to N, and may be mapped to a second PPM symbol 420.

Furthermore, a last bit 431 from among the coded information bits for level 1, a last bit 433 from among the coded information bits for level 2, and a last bit 435 from among the coded information bits for level N may be concatenated in the sequence of levels 1 to N, and may be mapped to a last PPM symbol 430.

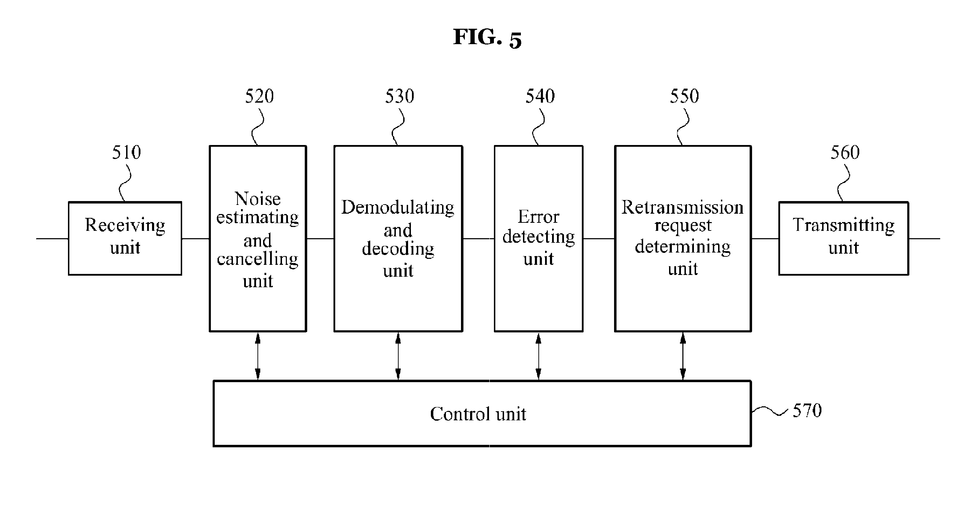

FIG. 5 illustrates an example of a hierarchical demodulation apparatus.

Referring to FIG. 5, the hierarchical demodulation apparatus includes a receiving unit 510, a noise estimating and cancelling unit 520, a demodulating and decoding unit 530, an error detecting unit 540, a retransmission request determining unit 550, a transmitting unit 560, and a control unit 570. For example, the hierarchical demodulation apparatus of FIG. 5 may correspond to a receiver in a hierarchical modulation/demodulation system.

The demodulating and decoding unit 530 may demodulate a received signal based on a demodulation order, and may decode coded information bits. For example, the demodulating and decoding unit 530 may demodulate the received signal based on the demodulation order determined based on a performance of the receiver. In this example, a PPM signal may be received, and the demodulating and decoding unit 530 may perform a PPM demodulation scheme. For example, the demodulating and decoding unit 530 may estimate a position of a PPM symbol included in the received signal. The demodulating and decoding unit 530 may estimate a parity from the coded information bits. A signal that is output from the demodulating and decoding unit 530 may include an error verification code and information bits that are concatenated for each level by a transmitter of the hierarchical modulation/demodulation system.

The error detecting unit 540 may detect an error from the received signal. For example, the error may be detected based on an error verification code included in the coded information bits. The error verification code may include, for example, a CRC code. The error detecting unit 540 may determine information bits in which an error occurs, from among the coded information bits, by checking CRC bits.

The demodulating and decoding unit 530 may demodulate the received signal using PPM symbols based on the demodulation order, and may estimate bit values from level 1 to a level corresponding to the demodulation order, from the demodulated signal.

The error detecting unit 540 may detect the error from the received signal based on a CRC code that is included in the estimated bits values. For example, the demodulation order may be set to 'K,' and the demodulating and decoding unit 530 may include 'K' branch demodulating and decoding units. Each of the 'K' branch demodulating and decoding units may estimate bits for levels 1 to K, using an iterative decoding scheme. In this example, the iterative decoding scheme may enable the 'K' branch demodulating and decoding units to exchange extrinsic information with each other.

For example, a K^{th} branch demodulating and decoding unit may estimate bits for levels 1 to K, and a (K-1)^{th} branch demodulating and decoding unit may estimate bits for levels 1 to K-1. In this example, the (K-1)^{th} branch demodulating and decoding unit may use a priori probability, for example, a posteriori probability of each of the bits calculated by the K-th branch demodulating and decoding unit. A first branch demodulating and decoding unit may estimate bits for level 1. In this example, K indicating a demodulation order may be set to be less than or equal to N indicating a modulation order.

The error detecting unit 540 may include 'K' branch error detecting units that are respectively connected to the 'K' branch demodulating and decoding units. Each of the branch error detecting units may detect an error from the estimated bits for each level based on the CRC code included in the estimated bits. For example, a K^{th} branch error detecting unit connected to the K^{th} branch demodulating and decoding unit may determine whether an error occurs in the estimated bits for levels 1 to K based on the CRC code.

The noise estimating and cancelling unit 520 may estimate noise that may be generated due to a difference between a modulation order of the transmitter and a demodulation order of the receiver, and may cancel or otherwise reduce the estimated noise.

In response to the error being detected from the received signal, the retransmission request determining unit 550 may determine whether to request the transmitter to retransmit information bits for a level that is higher than a level in which the error is detected. For example, the retransmission request determining unit 550 may request retransmission of information bits if the transmitter enables providing of information regarding the same source to the receiver. If a real-time broadcast is used as a source, the requesting for retransmission of information bits may be difficult because information on the source varies depending on time. As another example, if the transmitter transmits a signal in a broadcast manner, requesting the transmitter to retransmit information bits may also be difficult. In another example, color information of a stored image may remain unchanged despite a change in time, and accordingly requesting for retransmission of information bits may be possible.

The receiving unit 510 may receive PPM symbols. The receiving unit 510 may receive a received signal including the PPM symbols from the transmitter.

The transmitting unit 560 may transmit a response signal. The response signal may include information on a level in which an error is detected, and information on the demodulation order. For example, the transmitting unit 560 may transmit, to the transmitter, an error verification code in which an error occurs, and the demodulation order of the receiver.

For purposes of example, the demodulation order may be set to '3,' and the transmitting unit 560 may verify operation results of three branch demodulating and decoding units. If an error occurs in only an output value of a third branch demodulating and decoding unit, the transmitting unit 560 may determine that an error occurs in only a third bit among three estimated information bits. Additionally, the transmitting unit 560 may transmit a response signal including information notifying that the error occurs in the third bit.

In various examples, the transmitter may adjust the modulation order based on the demodulation order, and may retransmit an information bit in which an error occurs.

As another example, the demodulation order may be set to 'K.' If an error is not detected from an output value of a K^{th} branch demodulating and decoding unit, the control unit 570 may determine final estimated information bits, and may control the other branch demodulating and decoding units not to be operated. In this example, the control unit 570 may determine whether an error occurs in the output value of the K^{th} branch demodulating and decoding unit, first, among K branch demodulating and decoding units. Accordingly, time and energy used for decoding may be reduced.

The control unit 570 may control an overall operation of the hierarchical demodulation apparatus of FIG. 5, and may perform one or more functions of one or more of the receiving unit 510, the noise estimating and cancelling unit 520, the demodulating and decoding unit 530, the error detecting unit 540, the retransmission request determining unit 550, and the transmitting unit 560. In this example, the receiving unit 510, the noise estimating and cancelling unit 520, the demodulating and decoding unit 530, the error detecting unit 540, the retransmission request determining unit 550, the transmitting unit 560, and the control unit 570 are separately illustrated in FIG. 5. However, it should be appreciated that the control unit 570 may be configured to perform one or more of the functions, or only a portion of the functions.

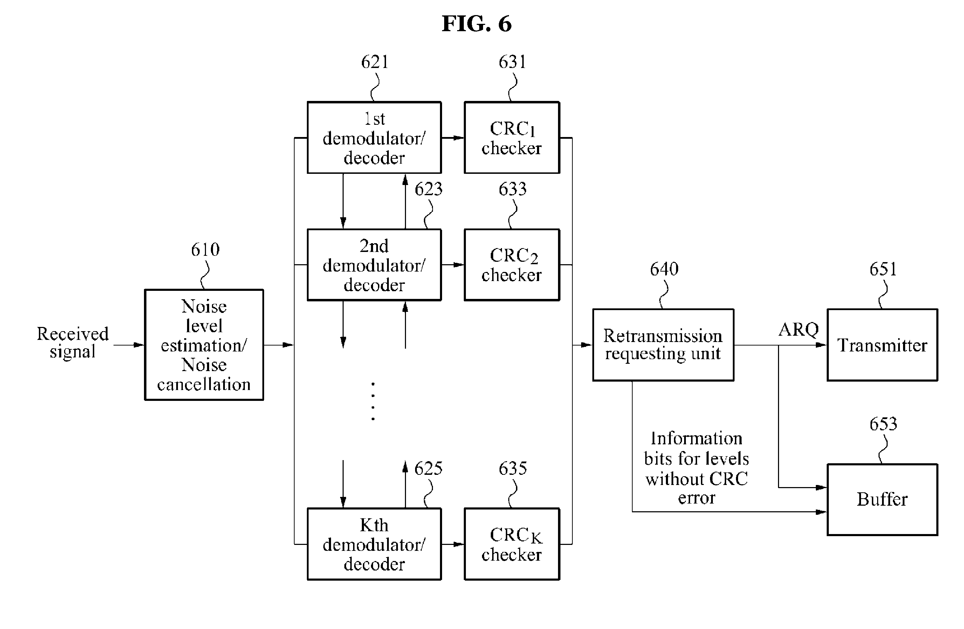

FIG. 6 illustrates another example of a hierarchical demodulation apparatus.

Referring to FIG. 6, the hierarchical demodulation apparatus may correspond to a receiver in a hierarchical modulation/demodulation system.

The hierarchical demodulation apparatus may demodulate and decode a received signal, which includes information bits for K levels. For example, the K levels may be determined based on a performance and situation of each receiver. K may be equal to or less than N (K ≤ N).

A transmitter configured to transmit a PPM signal modulated with a single modulation order (for example, an N-order modulation) may transmit information to various receivers.

A noise level estimation/noise cancellation unit 610 may estimate a noise level of the received signal, and may cancel or otherwise reduce noise for the estimated noise level, to prevent a noise enhancement phenomenon from occurring as a result of a difference between a modulation order and a demodulation order.

For example, the signal from which noise is cancelled may be input to K branches. A k^{th} branch may include a decoder for a parityₖ, a CRCₖ checker and a demodulator of a demodulation order k. In this example, k may be equal to or greater than '1' and equal to or less than 'K' (1 ≤ k ≤ K). The received signal may be input to 'K' demodulators/decoders, for example a first demodulator/decoder 621, a second demodulator/decoder 623, and a K^{th} demodulator/decoder 625, and may be input to 'K' CRC checkers, for example a CRC₁ checker 631, a CRC₂ checker 633, and a CRCₖ checker 635.

To improve performance, the first demodulator/decoder 621 through the K^{th} demodulator/decoder 625 may use an iterative decoding scheme to exchange extrinsic information with a neighboring branch.

The decoder of the k^{th} branch may calculate a posteriori probability, and may estimate bit values b₁ to bₖ for levels 1 to k. The calculated posteriori probability may be input as extrinsic information to a decoder of a neighboring branch, and may be used as a priori probability. The extrinsic information may be iteratively exchanged a predetermined number of times between branches, and a decoder of each of the branches may transmit a final estimated value to a CRC checker.

A receiver may perform demodulating, decoding and CRC checking on a K^{th} branch. If an error is not detected from the K^{th} branch, decoding and CRC checking may not be performed on the other branches. In other words, if the demodulating, decoding and CRC checking of the K^{th} branch are performed first, unnecessary complexity may be reduced.

If an error is detected from a CRCₖ, the receiver may request the transmitter to retransmit information bits for levels higher than level k. For example, if the retransmission of information bits is difficult or impossible, like a broadcasting signal, or if the receiver desires to complete receiving only information bits for levels 1 to k-1, the retransmission may not be requested.

In an example in which an error is not detected, a retransmission requesting unit 640 may transmit finally estimated information bits to a buffer 653 of the receiver. If retransmission of information bits is impossible or difficult, or is not relatively important, even if an error is detected, the retransmission requesting unit 640 may transmit the estimated information bits to the buffer 653, without requesting the retransmission. If the retransmission of information bits is requested due to detection of an error, the retransmission requesting unit 640 may transmit a retransmission request signal to a transmitter 651. The retransmission request signal may include, for example, an Automatic Repeat reQuest (ARQ).

FIGS. 7 through 10 illustrate examples of waveforms of PPM symbols with a constant period.

For example, FIG. 7 illustrates a waveform of a 2-ary PPM symbol with a constant period. For example, if a single level exists, a 2-ary PPM symbol may be used. In the example of FIG. 7, d₁ indicates a pulse duration, and P indicates a pulse power. Additionally, coded information bits mapped to pulses are marked on the pulses.

FIG. 8 illustrates a waveform of a 4-ary PPM symbol with a constant period. For example, if two levels exist, a 4-ary PPM symbol may be used. In the example of FIG. 8, d₂ indicates a pulse duration, and satisfies 'd₂ = 0.5 × d₁.' Additionally, coded information bits mapped to pulses are marked on the pulses, and refer to bits coded for levels 1 and 2 sequentially from left to right.

FIG. 9 illustrates a waveform of an 8-ary PPM symbol with a constant period. For example, if three levels exist, an 8-ary PPM symbol may be used. In the example of FIG. 9, d₃ indicates a pulse duration, and satisfies 'd₃ = 0.5 × d₂.' Additionally, coded information bits mapped to pulses are marked on the pulses, and refer to bits coded for levels 1 to 3 sequentially from left to right.

FIG. 10 illustrates a waveform of a 16-ary PPM symbol with a constant period. For example, if four levels exist, a 16-ary PPM symbol may be used. In the example of FIG. 10, d₄ indicates a pulse duration, and satisfies 'd₄ = 0.5 × d₃.' Additionally, coded information bits mapped to pulses are marked on the pulses, and refer to bits coded for levels 1 to 4 sequentially from left to right. FIGS. 8 through 10 illustrate examples of gray mapping.

FIGS. 11 through 14 illustrate examples of waveforms of PPM symbols with the same pulse durations. In the examples of FIGS. 11 through 14, d indicates a pulse duration, and remains unchanged, despite a change in a modulation order. Additionally, P indicates a pulse power, and coded information bits mapped to pulses are marked the pulses.

FIGS. 11 through 14 illustrate a waveform of a 2-ary PPM symbol, a waveform of a 4-ary PPM symbol, a waveform of an 8-ary PPM symbol, and a waveform of a 16-ary PPM symbol, respectively. The 2-ary PPM symbol, the 4-ary PPM symbol, the 8-ary PPM symbol, and the 16-ary PPM symbol may have the same pulse durations.

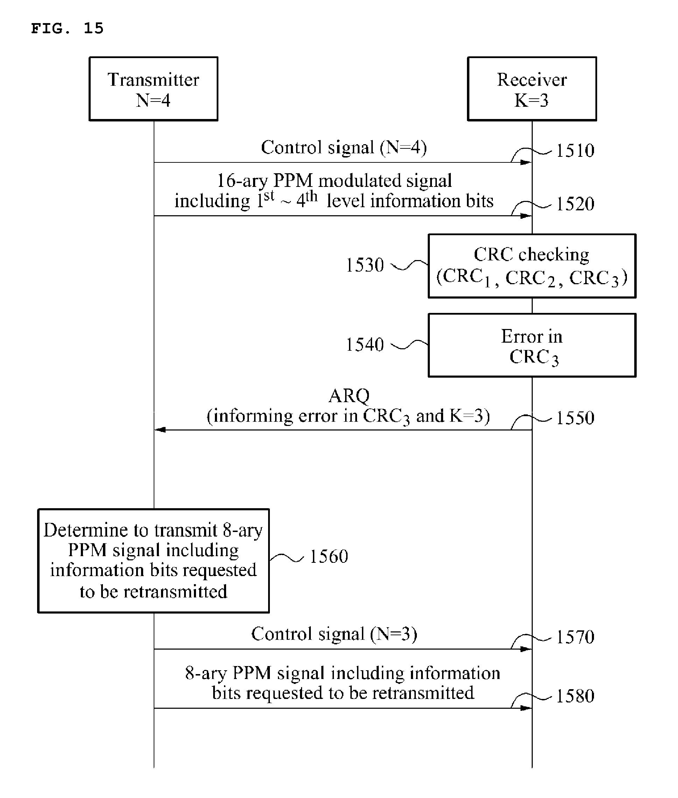

FIG. 15 illustrates an example of operations of a transmitter and a receiver in an example in which retransmission of information bits is possible in a hierarchical modulation/demodulation system. Referring to FIG. 15, a modulation order of the transmitter, and a demodulation order of the receiver are assumed to be 4 and 3, respectively. In FIG. 15, the modulation order and the demodulation order are denoted by 'N,' and 'K,' respectively.

In 1510, the transmitter transmits, to the receiver, a control signal including information on the modulation order determined if information regarding the receiver does not exist.

In 1520, the transmitter transmits, to the receiver, a 16-ary PPM signal to which information bits for a 1^{st} level to a 4^{th} level are mapped.

In 1530, the receiver demodulates and demotes the received 16-ary PPM modulated signal, and may detect an error from the information bits through CRC checking.

In 1540, the receiver determines that an error occurs in CRC₃, as a result of checking CRC₁, CRC₂, and CRC₃.

To inform the error occurring in CRC₃ and the demodulation order, in 1550 the receiver transmits, to the transmitter, an ARQ, for example, an ACK signal including information notifying that the error occurs in CRC₃ and information on the demodulation order.

In 1560, the transmitter adjusts the modulation order to be the same as the demodulation order, generates an 8-ary PPM signal to which information bits are mapped, and determines to transmit the 8-ary PPM signal to the receiver. For example, the information bits included in the 8-ary PPM signal may be requested by the receiver to be retransmitted due to the error in CRC3.

In 1570, the transmitter transmits a control signal to the receiver. For example, the control signal may include information on the modulation order adjusted to be identical to the demodulation order.

In 1580, the transmitter transmits the 8-ary PPM signal to the receiver.

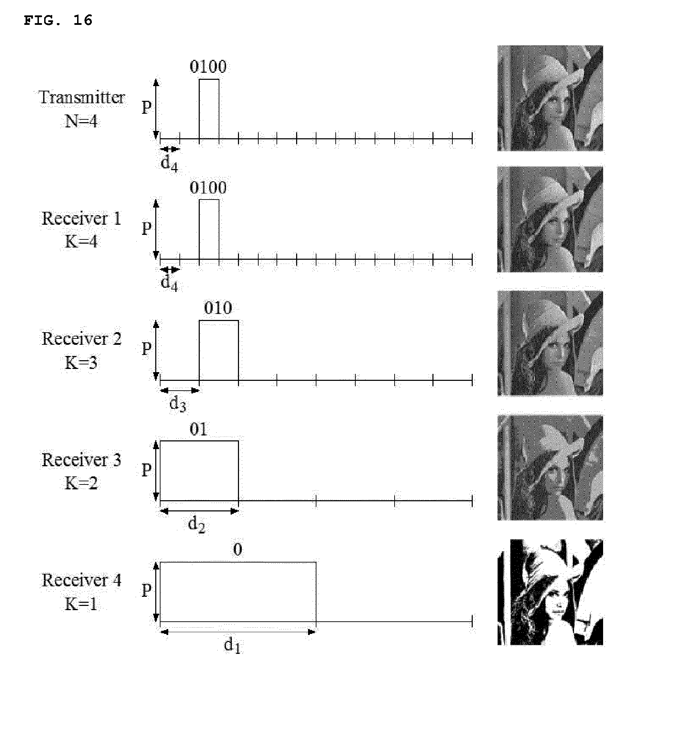

FIG. 16 illustrates an example of results of demodulating and decoding performed by receivers with various demodulation orders, in an example in which retransmission of information bits is impossible or difficult in a hierarchical modulation/demodulation system.

FIG. 16 illustrates an example in which receivers 1, 2, 3 and 4 simultaneously receive the same information (for example, a broadcasting signal) from a transmitter. In this example, because retransmission of information bits is impossible or difficult, each of the receivers 1 to 4 may determine a demodulation order based on a performance of each of the receivers 1 to 4 (for example, a bandwidth, a display quality, and the like), and may demodulate and decode a received signal based on the determined demodulation order. In FIG. 16, the transmitter transmits information on photographs, and accuracy of color representation differs for each level.

First, the transmitter may transmit a pulse in a position corresponding to information bits '0100' in 16-ary PPM symbols with a constant period, based on a modulation order N set to '4.' The position may be, for example, a third pulse interval from the left. The receivers 1 to 4 may demodulate received signals, based on demodulation orders K of the receivers 1 to 4 that are set to '4,' '3,' '2,' and '1,' respectively.

Because the demodulation order of the receiver 1 is the same as the modulation order of the transmitter, the receiver 1 may demodulate the received signal using the 16-ary PPM symbol of FIG. 10, similarly to the transmitter. If an error is not detected, the receiver 1 may estimate, as a position of a pulse, a third pulse interval from the left, and may estimate bits '0100' mapped to the 16-ary PPM symbol. The estimated position of the pulse may be the same as the position of the pulse received from the transmitter. A photograph acquired through decoding may have the same color representation level as an original photograph, because the modulation order is the same as the demodulation order.

Because the demodulation order of the receiver 2 is set to '3,' the receiver 2 may demodulate the received signal using the 8-ary PPM symbol of FIG. 9. The receiver 2 may estimate a position of a pulse based on the 8-ary PPM symbol. If an error is not detected, the receiver 2 may estimate, as the position of the pulse, a second pulse interval from the left based on the 8-ary PPM symbol, and may estimate bits '010' mapped to the 8-ary PPM symbol.

Similarly, the receivers 3 and 4 may demodulate the received signals based on the 4-ary PPM symbol of FIG. 8 and the 2-ary PPM symbol of FIG. 7, respectively. If an error is not detected, the receiver 3 may estimate, as a position of a pulse, a first pulse interval from the left based on the 4-ary PPM symbol, and the receiver 4 may estimate, as a position of a pulse, a first pulse interval from the left based on the 2-ary PPM symbol. Additionally, the receivers 3 and 4 may estimate bits '01' and '0' corresponding to the estimated pulse intervals, respectively.

In this example, color representation levels of photographs obtained by the receivers 2, 3, and 4 may be reduced in proportion to the demodulation orders of the receivers 2, 3, and 4. However, it is possible to acquire information on photographs, modulated based on the same modulation order, based on a demodulation order of each of a plurality of receivers. Additionally, it is possible to reduce complexity of implementation of a hierarchical modulation/demodulation system by using PPM symbols.

According to various examples herein, a hierarchical modulation apparatus may provide a non-coherent transmitter by mapping information bits to a Pulse-Position Modulation (PPM) signal for each level.

Additionally, a hierarchical demodulation apparatus may perform demodulating and decoding using a demodulation order determined based on a performance of a receiver, and thus it is possible to use a service employing hierarchical demodulation even in a receiver with limitations in structure and performance.

According to various examples herein, in a network environment using PPM, it is possible to simultaneously provide a service to a plurality of receivers that are different in functions of a device and communication environment.

It is possible to improve receiving performance and reduce a number of retransmissions of information bits, by performing an iterative decoding scheme using branch demodulators/decoders.

If an error is not detected from a channel, only demodulating and decoding of a last branch demodulator/decoder may be performed, and thus it is possible to reduce complexity of a receiver.

Program instructions to perform a method described herein, or one or more operations thereof, may be recorded, stored, or fixed in one or more computer-readable storage media. The program instructions may be implemented by a computer. For example, the computer may cause a processor to execute the program instructions. The media may include, alone or in combination with the program instructions, data files, data structures, and the like. Examples of computer-readable storage media include magnetic media, such as hard disks, floppy disks, and magnetic tape; optical media such as CD ROM disks and DVDs; magneto-optical media, such as optical disks; and hardware devices that are specially configured to store and perform program instructions, such as read-only memory (ROM), random access memory (RAM), flash memory, and the like. Examples of program instructions include machine code, such as produced by a compiler, and files containing higher level code that may be executed by the computer using an interpreter. The program instructions, that is, software, may be distributed over network coupled computer systems so that the software is stored and executed in a distributed fashion. For example, the software and data may be stored by one or more computer readable storage mediums. Also, functional programs, codes, and code segments for accomplishing the example embodiments disclosed herein can be easily construed by programmers skilled in the art to which the embodiments pertain based on and using the flow diagrams and block diagrams of the figures and their corresponding descriptions as provided herein. Also, the described unit to perform an operation or a method may be hardware, software, or some combination of hardware and software. For example, the unit may be a software package running on a computer or the computer on which that software is running.

As a non-exhaustive illustration only, a terminal/device/unit described herein may refer to mobile devices such as a cellular phone, a personal digital assistant (PDA), a digital camera, a portable game console, and an MP3 player, a portable/personal multimedia player (PMP), a handheld e-book, a portable laptop PC, a global positioning system (GPS) navigation, a tablet, a sensor, and devices such as a desktop PC, a high definition television (HDTV), an optical disc player, a setup box, a home appliance, and the like that are capable of wireless communication or network communication consistent with that which is disclosed herein.

A computing system or a computer may include a microprocessor that is electrically connected with a bus, a user interface, and a memory controller. It may further include a flash memory device. The flash memory device may store N-bit data via the memory controller. The N-bit data is processed or will be processed by the microprocessor and N may be 1 or an integer greater than 1. Where the computing system or computer is a mobile apparatus, a battery may be additionally provided to supply operation voltage of the computing system or computer. It will be apparent to those of ordinary skill in the art that the computing system or computer may further include an application chipset, a camera image processor (CIS), a mobile Dynamic Random Access Memory (DRAM), and the like. The memory controller and the flash memory device may constitute a solid state drive/disk (SSD) that uses a nonvolatile memory to store data.

A number of examples have been described above. Nevertheless, it will be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

## Claims

1. A hierarchical modulation apparatus, comprising:
a level mapping unit configured to map information bits to a plurality of levels based on a predetermined level map;
an error control unit configured to generate an error verification code for each of the levels based on the mapped information bits;
an encoding unit configured to generate coded information bits for each of the levels, based on the generated error verification code and the mapped information bits; and
a symbol mapping unit configured to map bits at a predetermined position among the coded information bits, to Pulse-Position Modulation (PPM) symbols, in a sequence of the levels.

2. The hierarchical modulation apparatus of claim 1, wherein the level mapping unit is configured to map the information bits to 'N' levels from levels 1 through N, and the error control unit is configured to generate an error verification code for level N by accumulating each of the information bits mapped for levels 1 through N,
wherein the encoding unit is preferably configured to generate a parity for level N, based on the error verification code for level N and the information bits mapped for levels 1 through N, and to generate coded information bits for level N by concatenating the parity for level N, the information bits mapped to level N, and the error verification code for level N,
wherein the symbol mapping unit is preferably configured to select a single bit from among the coded information bits for each of the 'N' levels, concatenate the selected bits in a sequence of the 'N' levels, and map the concatenated bits to the PPM symbols, or perform gray mapping to map the concatenated bits to the PPM symbols.

3. The hierarchical modulation apparatus of any of claims 1-4, wherein the PPM symbols comprise a constant period regardless of a number of the levels, or
wherein the PPM symbols comprise the same pulse durations regardless of a number of the levels.

4. The hierarchical modulation apparatus of any of claim 1-3, further comprising:
a transmitting unit configured to transmit a control signal comprising information about the modulation of the levels; and
a receiving unit configured to receive a response signal comprising error occurrence information and information on a demodulation order, preferably further comprising:
a control unit configured to map information bits to a PPM symbol based on the same modulation order as the demodulation order, and based on the error occurrence information and the information on the demodulation order received by the receiving unit, in response to the information bits being requested to be retransmitted,
wherein the hierarchical modulation apparatus is preferably included in a sensor in a Wireless Sensor Network (WSN).

5. A hierarchical demodulation apparatus, comprising:
a demodulating and decoding unit configured to demodulate a received signal based on a demodulation order, and to decode coded information bits; and
an error detecting unit configured to detect an error from the received signal, based on an error verification code that is included in the coded information bits.

6. The hierarchical demodulation apparatus of claim 5, wherein the demodulating and decoding unit is configured to demodulate the received signal using Pulse-Position Modulation (PPM) symbols based on the demodulation order, and estimate, from the demodulated signal, bit values from level 1 to a level corresponding to the demodulation order.

7. The hierarchical demodulation apparatus of claim 5 or 6, wherein the error detecting unit is configured to detect the error from the received signal based on a Cyclic Redundancy Check (CRC) code that is included in the estimated bit values.

8. The hierarchical demodulation apparatus of claim 11, further comprising:
a noise estimating and cancelling unit configured to estimate noise generated due to a difference between a modulation order of a transmitter and a demodulation order of a receiver, and to remove the estimated noise, preferably further comprising:
a retransmission request determining unit configured to determine whether to request the transmitter to retransmit information bits for a level that is higher than a level in which the error is detected, in response to the error being detected in the received signal, preferably further comprising:
a receiving unit configured to receive PPM symbols; and
a transmitting unit configured to transmit a response signal that comprises information about a level in which the error is detected, and information about the demodulation order.

9. The hierarchical demodulation apparatus of claim 11, wherein the demodulation order is set to 'K,' and the demodulating and decoding unit comprises 'K' branch demodulating and decoding units, and
each of the 'K' branch demodulating and decoding units is configured to estimate bits for levels 1 to K, respectively, using an iterative decoding scheme that enables the 'K' branch demodulating and decoding units to exchange extrinsic information with each other,
wherein the error detecting unit preferably comprises 'K' branch error detecting units that are respectively connected to the 'K' branch demodulating and decoding units, and
each of the 'K' branch error detecting units is configured to detect an error from the estimated bits for each level, respectively, based on a CRC code included in the estimated bits.
wherein the error detecting unit preferably comprises 'K' branch error detecting units that are respectively connected to the 'K' branch demodulating and decoding units, and
the 'K^{th}' branch error detecting unit is configured to detect an error from the estimated bits for the 1^{st} level to the K^{th} level based on a CRC code included in the estimated bits prior to the remaining branch error detecting units performing detecting,
wherein, preferably in response to the K^{th} branch error detecting unit not detecting an error, the remaining branch error detecting units are controlled not to operate,
wherein the hierarchical demodulation apparatus is included preferably in a sensor in a Wireless Sensor Network (WSN).

10. A hierarchical modulation method, comprising:
mapping information bits to a plurality of levels based on a predetermined level map;
generating an error verification code for each of the levels based on the mapped information bits;
generating coded information bits for each of the levels based on the generated error verification code and the mapped information bits; and
mapping bits at a predetermined position among the coded information bits, to Pulse-Position Modulation (PPM) symbols, in a sequence of the levels.

11. The hierarchical modulation method of claim 10,
wherein the information bits are mapped to 'N' levels from levels 1 through N, and the generating of the error verification code comprises generating an error verification code for level N by accumulating each of the information bits mapped for levels 1 through N,
wherein the generating of the coded information bits comprises preferably generating a parity for level N, based on the error verification code for level N and the information bits mapped for levels 1 through N, and generating coded information bits for level N by concatenating the parity for level N, the information bits mapped to level N, and the error verification code for level N,
wherein the mapping of the bits preferably comprises selecting a single bit from among the coded information bits for each of 'N' levels, concatenating the selected bits in a sequence of the 'N' levels, and mapping the concatenated bits to the PPM symbols.

12. The method of claim 10 or 11, wherein the apparatus of any of claims 1-4 is used.

13. A hierarchical demodulation method, comprising:
demodulating a received signal based on a demodulation order;
decoding coded information bits; and
detecting an error from the received signal, based on an error verification code included in the coded information bits.

14. The hierarchical demodulation method of claim 26, wherein the demodulating comprises demodulating the received signal using Pulse-Position Modulation (PPM) symbols based on the demodulation order, and
the decoding comprises estimating, from the demodulated signal, bit values from level 1 to a level corresponding to the demodulation order.

15. The method of claims 13 or 14, wherein the apparatus of any of claims 5-9 is used.
